# EUROPÄISCHE PATENTSCHRIFT

(11) **EP 1 974 073 B1**
(45) Veröffentlichungstag und Bekanntmachung des Hinweises auf die Patenterteilung: **21.08.2013**
(21) Anmeldenummer: 07717815.0
(22) Anmeldetag: 10.01.2007
(51) Int. Cl.: C23C 28/00, C23C 14/08

(54) **VERSCHLEISSSCHUTZBESCHICHTUNG**
WEAR-RESISTANT COATING
REVETEMENT ANTI-USURE

(30) Priorität: 13.01.2006 DE 102006001864
(43) Veröffentlichungstag der Anmeldung: 01.10.2008
(73) Patentinhaber: MTU Aero Engines GmbH, 80995 München (DE)
(72) Erfinder: EICHMANN, Wolfgang, 82178 Puchheim (DE); HEUTLING, Falko, 81377 München (DE); UIHLEIN, Thomas, 85221 Dachau (DE)
(86) Internationale Anmeldenummer: PCT/DE2007/000018
(87) Internationale Veröffentlichungsnummer: WO 2007/079721

(56) Entgegenhaltungen:
- EP-A- 1 536 039
- EP-A1- 0 415 217
- EP-A1- 0 940 480
- EP-B1- 0 962 545
- WO-A-93/18199
- GB-A- 2 252 567
- GB-A- 2 398 799
- US-A- 5 687 679
- US-A1- 2005 013 994
- US-B1- 6 764 779

## Beschreibung

Die Erfindung betrifft eine Verschleißschutzbeschichtung nach dem Oberbegriff des Anspruchs 1.

Aus dem Stand der Technik ist es bekannt, Gasturbinenbauteile zum Schutz derselben gegenüber Verschleiß, insbesondere zum Schutz gegenüber Korrosion, an Oberflächen mit Verschleißschutzbeschichtungen zu versehen. So sind aus dem Stand der Technik Verschleißschutzbeschichtungen mit einem horizontal segmentierten bzw. einem mehrschichtigen Aufbau bekannt, die mindestens eine harte, keramische Schicht und mindestens eine weiche, metallische Schicht umfassen. Die keramischen Schichten sowie die metallischen Schichten solcher mehrschichtigen bzw. horizontal segmentierten Verschleißschutzbeschichtungen sind wechselweise übereinander angeordnet, und zwar derart, dass eine außenliegende Schicht, die eine äußere Oberfläche der Verschleißschutzbeschichtung bildet, als keramische Schicht ausgebildet ist. Solche mehrschichtigen bzw. horizontal segmentierten Verschleißschutzbeschichtungen werden auch als Multilayer-Verschleißschutzbeschichtungen bezeichnet. Bei aus dem Stand der Technik bekannten Multilayer-Verschleißschutzbeschichtungen sind sowohl die harten, keramischen Schichten als auch die weichen, metallischen Schichten durch eine kompakte, dichte und in sich geschlossene Schichtstruktur gekennzeichnet. Solche Mulitlayer-Verschleißschutzschichten sind beispielsweise aus den Druckschriften GB 2 252 567 A, EP 0 962 545 B1, US 6,764,779 B1 und aus EP 0 366 289 A1 bekannt. Solche Verschleißschutzbeschichtungen sind relativ empfindlich gegenüber Erosion. Werden dieselben einem Partikelerosionsangriff ausgesetzt, so ist festzustellen, dass sich nach einer relativ kurzen Initiierungsphase ein großflächiges Abplatzen der Verschleißschutzbeschichtung einstellt, insbesondere im Bereich der außenliegenden Schicht der Multilayer-Verschleißschutzbeschichtung, welche die äußere Oberfläche der Verschleißschutzbeschichtung bildet. Dies ist von Nachteil.

Hiervon ausgehend liegt der vorliegenden Erfindung das Problem zu Grunde, eine neuartige Verschleißschutzbeschichtung zu schaffen.

Dieses Problem wird durch eine Verschleißschutzbeschichtung gemäß Anspruch 1 gelöst.

Im Sinne der hier vorliegenden Erfindung sind zumindest die außenliegende erste keramische Schicht und die sich unter Zwischenschaltung einer metallischen Schicht an die außenliegende erste keramische Schicht anschließende zweite keramische Schicht in vertikaler Richtung kolumnar segmentiert, wobei die beiden innenliegenden keramischen Schichten in vertikaler Richtung unsegmentiert sind.

Durch die kolumnare Segmentierung der Verschleißschutzbeschichtung zumindest im Bereich der außenliegenden Schicht derselben wird das z.B. durch einen Partikelerosionsangriff verursachte Abplatzen der Verschleißschutzbeschichtung auf räumlich sehr kleine Bereiche begrenzt, so dass die erfindungsgemäße Verschleißschutzbeschichtung über eine gute Erosionsbeständigkeit verfügt. Zwischen Kolumnen der kolumnar segmentierten, außenliegenden Schicht der Verschleißschutzbeschichtung sind Grenzflächen ausgebildet, die durch Verschleißbelastungen wie z.B. Erosionsbelastungen hervorgerufene Mikrorisse am Wachstum hindern. Vielmehr wird durch die Grenzflächen eine starke Verzweigung der Mikrorisse unter Bildung von Rissnetzwerken in kleinen Materialvolumen verursacht. Die Bildung solcher, stark verzweigter Rissnetzwerke ist mit einem hohen Maß an Energieabsorption verbunden, so dass die erfindungsgemäße Verschleißschutzbeschichtung die insbesondere bei einem Partikelerosionsangriff auf dieselbe einwirkende Energie gut absorbieren kann. Ein Ausbreiten von infolge eines Partikelerosionsangriffs abplatzenden Bereichen der Verschleißschutzbeschichtung kann demnach effektiv verhindert werden.

Nach einer vorteilhaften Weiterbildung der Erfindung ist zumindest die außenliegende, keramische Schicht, die in vertikaler Richtung kolumnar segmentiert ist, nanostrukturiert ausgebildet.

Die oder jede in vertikaler Richtung kolumnar segmentierte Schicht ist entweder kolumnar säulenförmig oder kolumnar stängelig oder kolumnar faserförmig strukturiert.

Bevorzugte Weiterbildungen der Erfindung ergeben sich aus den Unteransprüchen und der nachfolgenden Beschreibung. Ausführungsbeispiele der Erfindung werden, ohne hierauf beschränkt zu sein, an Hand der Zeichnung näher erläutert. Dabei zeigt:
- Fig. 1: eine schematisierte Darstellung einer aus dem Stand der Technik bekannten, auf ein Gasturbinenbauteil aufgebrachten Verschleißschutzbeschichtung,
- Fig. 2: eine schematisierte Darstellung einer aus dem Stand der Technik bekannten, auf ein Gasturbinenbauteil aufgebrachten Verschleißschutzbeschichtung,
- Fig. 3: ein Detail der Verschleißschutzbeschichtung gemäß Fig. 2, wobei die außenliegende, keramische Schicht kolumnar säulenförmig strukturiert ist,
- Fig. 4: ein alternatives Detail der Verschleißschutzbeschichtung gemäß Fig. 2, wobei die außenliegende, keramische Schicht kolumnar stängelig strukturiert ist,
- Fig. 5: ein alternatives Detail der Verschleißschutzbeschichtung gemäß Fig. 2, wobei die außenliegende, keramische Schicht kolumnar faserförmig strukturiert ist,
- Fig. 6: eine schematisierte Darstellung einer erfindungsgemäßen, auf ein Gasturbinenbauteil aufgebrachten Verschleißschutzbeschichtung
- Fig. 7: eine schematisierte Darstellung einer aus dem Stand der Technik bekannten, auf ein Gasturbinenbauteil aufgebrachten Verschleißschutzbeschichtung.

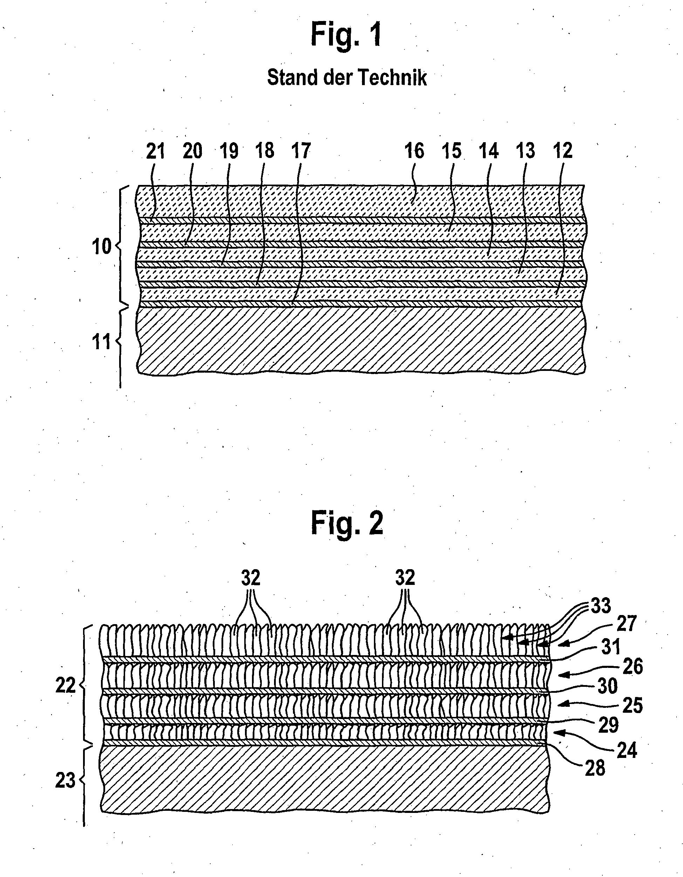

Bevor nachfolgend die hier vorliegende Erfindung unter Bezugnahme auf Fig. 2 bis 7 in größerem Detail beschrieben wird, soll vorab unter Bezugnahme auf Fig. 1 der Stand der Technik dargestellt werden.

Fig. 1 zeigt eine aus dem Stand der Technik bekannte Verschleißschutzbeschichtung 10, die auf eine äußere Oberfläche eines Gasturbinenbauteils 11 aufgebracht ist. Die Verschleißschutzbeschichtung 10 der Fig. 1 verfügt über einen mehrschichtigen Aufbau und ist demnach horizontal segmentiert. So verfügt die mehrschichtige bzw. horizontal segmentierte Verschleißschutzbeschichtung 10 über mehrere harte, keramische Schichten 12, 13, 14, 15 und 16 sowie über mehrere weiche, metallische Schichten 17, 18, 19, 20 und 21. Die keramischen Schichten 12 bis 16 und die metallischen Schichten 17 bis 21 sind jeweils wechselweise derart übereinander angeordnet, dass zwischen zwei benachbarten keramischen Schichten 12 und 13 bzw. 13 und 14 bzw. 14 und 15 bzw. 15 und 16 jeweils eine metallische Schicht 18 bzw. 19. bzw. 20 bzw. 21 angeordnet ist.

Eine außenliegende Schicht 16 der Verschleißschutzbeschichtung 10, die eine äußere Oberfläche der Verschleißschutzbeschichtung bildet, ist als keramische Schicht ausgebildet. Eine innenliegende Schicht 17 der Verschleißschutzbeschichtung, die auf die Oberfläche des Gasturbinenbauteils 11 aufgebracht ist, ist hingegen als metallische Schicht ausgeführt. Bei der aus dem Stand der Technik bekannten Verschleißschutzbeschichtung 10 gemäß Fig. 1 sind alle harten, keramischen Schichten 12 bis 16 sowie alle weichen, metallischen Schichten 17 bis 21 als kompakte bzw. dichte, in sich geschlossene Schichten ausgebildet.

Derartige aus dem Stand der Technik bekannte Verschleißschutzbeschichtungen sind relativ empfindlich gegenüber Erosion, da dieselben z.B. bei einem Partikelerosionsangriff die einwirkende Energie nicht gut absorbieren können. Vielmehr bilden sich bei solchen Verschleißschutzbeschichtungen Risse großflächig aus, so dass sich nach einer relativ kurzen Initiierungsphase ein großflächiges Abplatzen der aus dem Stand der Technik bekannten Verschleißschutzbeschichtung einstellt.

Fig. 2 zeigt ein Ausführungsbeispiel einer aus dem Stand der Tecknik bekannten Verschleißschutzbeschichtung 22, die auf einem Gasturbinenbauteil 23 aufgebracht ist. Die Verschleißschutzbeschichtung 22 der Fig. 2 verfügt wiederum über mehrere harte, keramische Schichten 24, 25, 26 und 27 sowie über mehrere weiche, metallische Schichten 28, 29, 30 und 31. Die harten, keramischen Schichten 24 bis 27 sowie die weichen, metallischen Schichten 28 bis 31 sind wechselweise übereinander auf das Gasturbinenbauteil 23 aufgebracht, und zwar derart, dass zwischen zwei benachbarten keramischen Schichten 24 und 25 bzw. 25 und 26 bzw. 26 und 27 jeweils eine metallische Schicht 29 bzw. 30 bzw. 31 angeordnet ist. Eine außenliegende Schicht 27, die eine äußere Oberfläche der Verschleißschutzbeschichtung 22 bildet, ist als keramische Schicht ausgebildet. Eine innenliegende Schicht 28, die unmittelbar auf das Gasturbinenbauteil 23 aufgebracht ist, ist als metallische Schicht ausgeführt.

Bei der Verschleißschutzbeschichtung 22 ist zumindest die außenliegende, keramische Schicht 27 , welche die äußere Oberfläche der Verschleißschutzbeschichtung bildet, in vertikaler Richtung kolumnar segmentiert. Im Ausführungsbeispiel der Fig. 2 sind alle keramischen Schichten 24, 25, 26 und 27, inklusive der außenliegenden keramischen Schicht 27, in vertikaler Richtung kolumnar segmentiert. Innerhalb jeder der keramischen Schichten 24 bis 27 sind demnach Kolumnen 32 ausgebildet, die durch Grenzflächen 33 voneinander getrennt sind.

Im Ausführungsbeispiel der Fig. 2 verlaufen die Grenzflächen 33 zwischen den Kolumnen 32 aller in vertikaler Richtung kolumnar segmentierten keramischen Schichten 24 bis 27 in etwa senkrecht zur Oberfläche des Gasturbinenbauteils. Die Kolumnen 32 sämtlicher kolumnar segmentierten, keramischen Schichten 24 bis 27 verfügen demnach im Ausführungsbeispiel der Fig. 2 über die gleiche Orientierung, wobei die Kolumnen 32 aller kolumnar segmentierten keramischen Schichten 24 bis 27 senkrecht zur Oberfläche des Gasturbinenbauteils 23 verlaufen und damit gegenüber der Oberfläche des Gasturbinenbauteils 23 nicht geneigt sind.

Durch die oben beschriebene kolumnare Segmentierung zumindest der außenliegenden, keramischen Schicht 27 der Verschleißschutzbeschichtung 22 können z.B. bei einem Partikelerosionsangriff auf die Verschleißschutzbeschichtung 22 einwirkende Kräfte gut absorbiert werden. Durch z.B. einen Partikelerosionsangriff hervorgerufene Mikrorisse werden durch die Grenzflächen 33 an einer Ausbreiten gehindert. Hierdurch wird ein eventuelles Abplatzen der außenliegenden Schicht 27 der Verschleißschutzbeschichtung 22 auf räumlich sehr kleine Bereiche begrenzt, so dass die Verschleißschutzbeschichtung 22 demnach über eine gute Erosionsbeständigkeit verfügt.

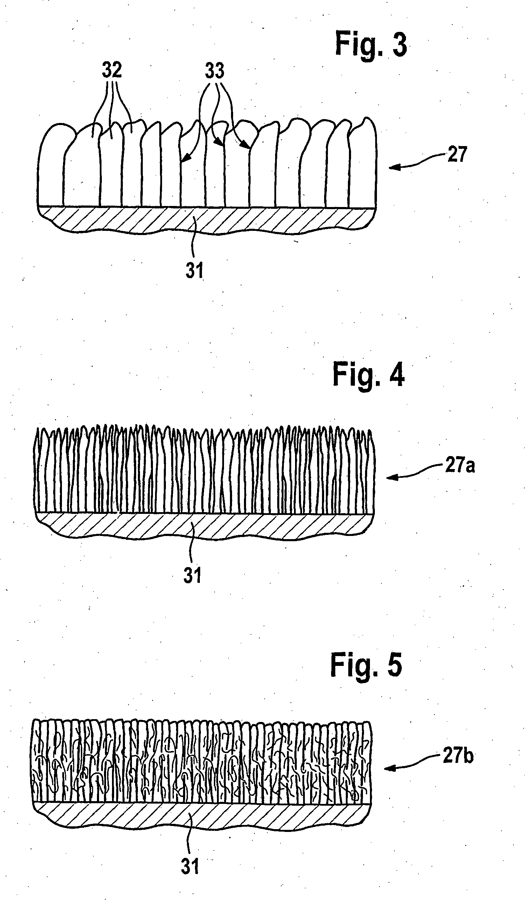

Fig. 3 zeigt ein Detail der Verschleißschutzbeschichtung 22 im Bereich der außenliegenden, keramischen Schicht 27, welche die äußere Oberfläche der Verschleißschutzbeschichtung 22 bildet und in vertikaler Richtung kolumnar segmentiert ist. So ist die Schicht 27 gemäß Fig. 3 säulenförmig kolumnar strukturiert. Alternativ kann die außenliegende, keramische Schicht sowie jede andere kolumnar segmentierte Schicht stängelig kolumnar oder faserförmig kolumnar strukturiert sein. Fig. 4 zeigt eine stängelig kolumnare Schicht 27a. Fig. 5 zeigt eine faserförmig kolumnare Schicht 27b.

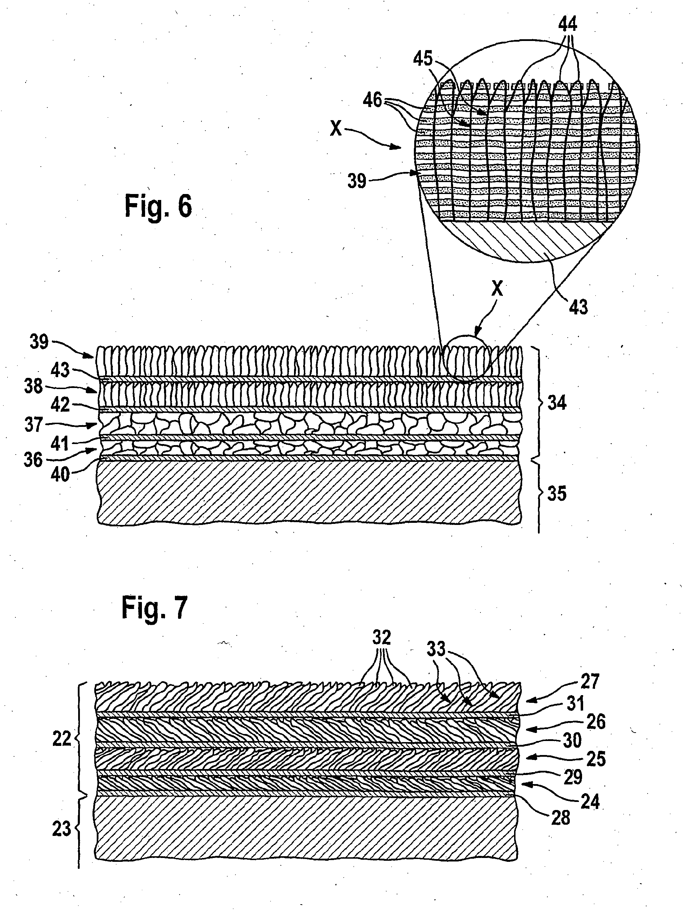

Im Ausführungsbeispiel der Fig. 2 sind die weichen, metallischen Schichten 28, 29, 30 und 31 als kompakte, dichte und damit in vertikaler Richtung unsegmentierte Schichten ausgebildet. Gegebenenfalls können auch die metallischen Schichten 28 bis 31 kolumnar segmentiert sein. Es kann auch nur ein Teil der metallischen Schichten kolumnar segmentiert sein. Ein Ausführungsbeispiel einer erfindungsgemäßen Verschleißschutzbeschichtung 34, die auf ein Gasturbinenbauteil 35 aufgebracht ist, zeigt Fig. 6.

So verfügt die Verschleißschutzbeschichtung 34 des Ausführungsbeispiels der Fig. 6 über mehrere harte, keramische Schichten 36, 37, 38 und 39 sowie über mehrere weiche, metallische Schichten 40, 41, 42 und 43, die wiederum wechselweise übereinander auf das Gasturbinenbauteil 35 aufgebracht sind. Im Ausführungsbeispiel der Fig. 6 sind lediglich zwei keramischen Lagen in vertikaler Richtung kolumnar segmentiert, nämlich die außenliegende, die äußere Oberfläche der Verschleißschutzbeschichtung 34 bildende Schicht 39 sowie die sich unter Zwischenschaltung der metallischen Schicht 43 an die außenliegende Schicht 39 anschließende keramische Schicht 38. Die beiden innenliegenden keramischen Schichten 36 und 37 sind hingegen in vertikaler Richtung unsegmentiert, verfügen jedoch über einen nanokristallinen Aufbau.

In den in vertikaler Richtung kolumnar segmentierten, keramischen Schichten 38 und 39 sind wiederum mehrere Kolumnen 44 ausgebildet, die durch Grenzflächen 45 voneinander getrennt sind. Die Kolumnen 44 und damit die Grenzflächen 45 verlaufen im Ausführungsbeispiel der Fig. 6 ebenso wie im Ausführungsbeispiel der Fig. 2 in etwa senkrecht zur Oberfläche des Gasturbinenbauteils, die Kolumnen 44 bzw. Grenzflächen 45 sind demnach im Ausführungsbeispiel der Fig. 6 gegenüber dem Gasturbinenbauteil nicht geneigt.

Im Ausführungsbeispiel der Fig. 6 ist die außenliegende, keramische Schicht 39, die in vertikaler Richtung kolumnar segmentiert ist, nanostrukturiert ausgebildet. So zeigt das Detail X der Fig. 6, dass im gezeigten Ausführungsbeispiel die außenliegende Schicht 39 nanolagig ausgeführt ist. So sind gemäß dem Detail X mehrere Nanolagen 46 übereinander angeordnet, wobei die Nanolagen 46 im Wesentlichen in horizontaler Richtung verlaufen und über eine Dicke von < 1 µm verfügen. So können z.B. Nanolagen 46 aus unterschiedlichen Materialien wechselweise übereinander positioniert sein, so dass die in vertikaler Richtung kolumnar segmentierte keramische Schicht 39 in sich durch die Nanolagen 46 auch horizontal segmentiert ist.

Alternativ oder auch zusätzlich zur nanolagigen Strukturierung der außenliegenden, keramischen Schicht 39 kann dieselbe nanokristallin ausgebildet sein.

Ebenso ist es möglich, dass die einzelnen Nanolagen 46 aus nanogradierten Werkstoffen hergestellt sind.

Ein weiteres Ausführungsbeispiel einer aus dem Stand der Technik bekannten Verschleißschutzbeschichtung zeigt Fig. 7, wobei die Verschleißschutzbeschichtung der Fig. 7 prinzipiell wie die Verschleißschutzbeschichtung der Fig. 2 ausgebildet ist.

Abschließend sei darauf hingewiesen, dass zwischen der erfindungsgemäßen Verschleißschutzbeschichtung. 34 und dem Gasturbinenbauteil 23 bzw. 35, auf welche die erfindungsgemäße Verschleißschutzbeschichtung 34 aufgebracht ist, eine Haftvermittlungsschicht angeordnet sein kann. Die erfindungsgemäßen Verschleißschutzbeschichtung sind vorzugsweise in PVD-Sputtertechnik hergestellt.

## Patentansprüche

1. Verschleißschutzbeschichtung, insbesondere für Gasturbinenbauteile, mit einem horizontal segmentierten bzw. mehrschichtigen Aufbau, nämlich mit mindestens vier harte, keramische Schichten (24, 25, 26, 27; 36, 37, 38, 39) und mit mindestens vier weiche, metallische Schichten (28, 29, 30, 31; 40, 41, 42, 43), wobei die oder jede keramische Schicht sowie die metallischen Schichten wechselweise derart übereinander angeordnet sind, dass eine außenliegende Schicht (27; 39), die eine äußere Oberfläche der Verschleißschutzbeschichtung bildet, als keramische Schicht ausgebildet ist,
**dadurch gekennzeichnet,**
**dass** die außenliegende erste keramische Schicht (39) und die sich unter Zwischenschaltung einer metallischen Schicht (43) an die außenliegende erste keramische Schicht (39) anschließende zweite keramische Schicht in vertikaler Richtung kolumnar segmentiert sind, wobei die beiden innenliegenden keramischen Schichten (36, 37) in vertikaler Richtung unsegmentiert sind.

2. Verschleißschutzbeschichtung nach Anspruch 1,
**dadurch gekennzeichnet,**
**dass** zumindest die außenliegende, keramische Schicht (39), die in vertikaler Richtung kolumnar segmentiert ist, säulenförmig kolumnar segmentiert ist.

3. Verschleißschutzbeschichtung nach Anspruch 1,
**dadurch gekennzeichnet,**
**dass** zumindest die außenliegende, keramische Schicht (39), die in vertikaler Richtung kolumnar segmentiert ist, stängelig kolumnar segmentiert ist.

4. Verschleißschutzbeschichtung nach Anspruch 1,
**dadurch gekennzeichnet,**
**dass** zumindest die außenliegende, keramische Schicht (39), die in vertikaler Richtung kolumnar segmentiert ist, faserförmig kolumnar segmentiert ist.

5. Verschleißschutzbeschichtung nach einem oder mehreren der Ansprüche 1 bis 4,
**dadurch gekennzeichnet,**
**dass** zumindest die außenliegende, keramische Schicht (39), die in vertikaler Richtung kolumnar segmentiert ist, nanostrukturiert ausgebildet ist.

6. Verschleißschutzbeschichtung nach Anspruch 5,
**dadurch gekennzeichnet,**
**dass** zumindest die außenliegende, keramische Schicht (39) nanokristallin ausgebildet ist.

7. Verschleißschutzbeschichtung nach Anspruch 6,
**dadurch gekennzeichnet,**
**dass** zumindest die außenliegende, keramische Schicht (39) nanolagig ausgebildet ist.

8. Verschleißschutzbeschichtung nach einem oder mehreren der Ansprüche 1 bis 7,
**dadurch gekennzeichnet,**
**dass** die keramischen Schichten (26, 27) derart in vertikaler Richtung kolumnar segmentiert sind, dass unter Zwischenschaltung einer metallischen Schicht (29; 30; 31) aufeinanderfolgende keramische Schichten (26, 27) mit unterschiedlicher Orientierung kolumnar segmentiert sind.

9. Verschleißschutzbeschichtung nach Anspruch 8,
**dadurch gekennzeichnet,**
**dass** Kolumnen von in vertikaler Richtung kolumnar segmentierten keramischen Schichten, die unter Zwischenschaltung einer metallischen Schicht aufeinanderfolgen, im dreidimensionalen Raum in unterschiedliche Richtungen geneigt sind.

10. Verschleißschutzbeschichtung nach einem oder mehreren der Ansprüche 1 bis 9,
**dadurch gekennzeichnet,**
**dass** dieselbe in PVD-Sputtertechnik hergestellt ist.

## Claims

1. A wear-resistant coating, in particular for gas turbine components, having a horizontally segmented or multilayered structure, namely having at least four hard ceramic layers (24, 25, 26, 27; 36, 37, 38, 39) and having at least four soft metallic layers (28, 29, 30, 31; 40, 41, 42, 43), wherein the or each ceramic layer and also the metallic layers are arranged alternately one on top of the other in such a way that an external layer (27; 39) constituting an outer surface of the wear-resistant coating is formed as a ceramic layer,
**characterised in that**
the external first ceramic layer (39) and the second ceramic layer adjoining the external first ceramic layer (39) with interposition of a metallic layer (43) are segmented in a columnar manner in the vertical direction, wherein the two internal ceramic layers (36, 37) are non-segmented in the vertical direction.

2. A wear-resistant coating according to claim 1,
**characterised in that**
at least the external ceramic layer (39) that is segmented in a columnar manner in the vertical direction is segmented in a pillar-shaped columnar manner.

3. A wear-resistant coating according to claim 1,
**characterised in that**
at least the external ceramic layer (39) that is segmented in a columnar manner in the vertical direction is segmented in a rod-shaped columnar manner.

4. A wear-resistant coating according to claim 1,
**characterised in that**
at least the external ceramic layer (39) that is segmented in a columnar manner in the vertical direction is segmented in a fibre-shaped columnar manner.

5. A wear-resistant coating according to one or more of claims 1 to 4,
**characterised in that**
at least the external ceramic layer (39) that is segmented in a columnar manner in the vertical direction is formed in a nano-structured manner.

6. A wear-resistant coating according to claim 5,
**characterised in that**
at least the external ceramic layer (39) is formed in a nano-crystalline manner.

7. A wear-resistant coating according to claim 6,
**characterised in that**
at least the external ceramic layer (39) is formed in a nano-layered manner.

8. A wear-resistant coating according to one or more of claims 1 to 7,
**characterised in that**
the ceramic layers (26, 27) are segmented in a columnar manner in the vertical direction in such a way that ceramic layers (26, 27) that follow each other with interposition of a metallic layer (29; 30; 31) are segmented in a columnar manner with differing orientation.

9. A wear-resistant coating according to claim 8,
**characterised in that**
columns of ceramic layers that are segmented in a columnar manner in the vertical direction and follow each other with interposition of a metallic layer are inclined in different directions in three-dimensional space.

10. A wear-resistant coating according to one or more of claims 1 to 9,
**characterised in that**
the same is produced using a PVD sputtering technique.

## Revendications

1. Revêtement anti-usure, en particulier pour les éléments constitutifs des turbines à gaz, ayant une structure segmentée horizontalement ou multicouche, à savoir au moins quatre couche céramiques dures (24, 25, 26, 27 ; 36, 37, 38, 39) et au moins quatre couches métalliques tendres (28, 29, 30, 31 ; 40, 41, 42, 43), la ou chaque couche céramique ainsi que les couches métalliques étant placées alternativement l'une audessus de l'autre de telle manière qu'une couche extérieure (27 ; 39), laquelle forme une surface extérieure du revêtement anti-usure, se présente sous forme céramique,
**caractérisé en ce que**
la première couche céramique située à l'extérieur (39) et la deuxième couche céramique adjacente à la première couche céramique (39) par l'interposition d'une couche métallique (43) sont segmentées dans le sens vertical de façon colonnaire, les deux couches céramiques situées à l'intérieur (36, 37) n'étant pas segmentées dans le sens vertical.

2. Revêtement anti-usure selon la revendication 1,
**caractérisé en ce qu'**
au moins la couche céramique extérieure (39), segmentée dans le sens vertical de façon colonnaire, est segmentée de façon colonnaire en forme de colonnes.

3. Revêtement anti-usure selon la revendication 1,
**caractérisé en ce qu'**
au moins la couche céramique extérieure (39), segmentée dans le sens vertical de façon colonnaire, est segmentée de façon colonnaire en forme de tiges.

4. Revêtement anti-usure selon la revendication 1,
**caractérisé en ce qu'**
au moins la couche céramique extérieure (39), segmentée dans le sens vertical de façon colonnaire, est segmentée de façon colonnaire en forme de fibres

5. Revêtement anti-usure selon l'une quelconque ou plusieurs des revendications 1 à 4,
**caractérisé en ce qu'**
au moins la couche céramique extérieure (39), segmenté de façon colonnaire dans le sens vertical, est nanostructurée.

6. Revêtement anti-usure selon la revendication 5,
**caractérisé en ce qu'**
au moins la couche céramique extérieure (39) a une structure nanocristalline.

7. Revêtement anti-usure selon la revendication 6,
**caractérisé en ce qu'**
au moins la couche céramique extérieure (39) forme une nanocouche.

8. Revêtement anti-usure selon l'une quelconque ou plusieurs des revendications 1 à 7,
**caractérisé en ce que**
les couches céramique (26, 27) sont segmentées de façon colonnaire dans le sens vertical de telle manière que si l'on interpose une couche métallique (29 ; 30, 31) des couches céramiques successives (26, 27) sont segmentées de façon colonnaire avec une orientation différente.

9. Revêtement anti-usure selon la revendication 8,
**caractérisé en ce que**
les colonnes de couches céramiques segmentées de façon colonnaire dans le sens vertical, lesquelles se succèdent par l'interposition d'une couche métallique, sont inclinées dans différentes direction dans l'espace tridimensionnel.

10. Revêtement anti-usure selon l'une quelconque ou plusieurs des revendications 1 à 9,
**caractérisé en ce qu'**
il est fabriqué par pulvérisation cathodique PVD.
